(19) Europäisches Patentamt
European Patent Office
Office européen des brevets

(11) **EP 4 568 047 A2**

(12) **EUROPÄISCHE PATENTANMELDUNG**

(43) Veröffentlichungstag:
**11.06.2025   Patentblatt 2025/24**

(21) Anmeldenummer: **25165679.9**

(22) Anmeldetag: **23.08.2019**

(51) Internationale Patentklassifikation (IPC):
**H02J 3/00** (2006.01)

(52) Gemeinsame Patentklassifikation (CPC):
**G01R 19/2513; G01R 23/177; H02J 3/0012;**
**H02J 3/241; H02J 3/381;** H02J 2300/28;
Y02E 10/76

(84) Benannte Vertragsstaaten:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorität: **24.08.2018   DE 102018120768**

(62) Dokumentnummer(n) der früheren Anmeldung(en)
nach Art. 76 EPÜ:
**19758725.6 / 3 841 650**

(71) Anmelder: **Wobben Properties GmbH**
**26607 Aurich (DE)**

(72) Erfinder:
• **Schwanka Trevisan, Aramis**
  **26605 Aurich (DE)**
• **Malekian Boroujeni, Kaveh**
  **28201 Bremen (DE)**

(74) Vertreter: **Eisenführ Speiser**
**Patentanwälte Rechtsanwälte PartGmbB**
**Postfach 10 60 78**
**28060 Bremen (DE)**

Bemerkungen:
24-03-2025 als Teilanmeldung zu der unter INID-
Code 62 erwähnten Anmeldung eingereicht worden.

(54) **WINDENERGIEANLAGE UND VERFAHREN ZUM ERKENNEN NIEDERFREQUENTER SCHWINGUNGEN IN EINEM ELEKTRISCHEN VERSORGUNGSNETZ**

(57)    Die Erfindung betrifft ein Verfahren zum Erkennen niederfrequenter Schwingungen, insbesondere subsynchroner Resonanzen, in einem elektrischen Versorgungsnetz, wobei das elektrische Versorgungsnetz eine Netzspannung mit einer Netznennfrequenz aufweist, umfassend die Schritte Aufnehmen wenigstens einer, mehrere Messpunkte aufweisenden Messreihe einer Netzgröße, insbesondere der Netzspannung, einem Einspeisestrom oder einer Netzfrequenz, über einen Messzeitraum, zum Durchführen einer Frequenzanalyse, Multiplizieren der Messreihe mit einer von der Zeit abhängigen sinusförmigen Prüffunktion für denselben Messzeitraum, wobei die Prüffunktion durch eine Prüffrequenz und einen Prüfwinkel als Phasenwinkel gekennzeichnet ist, und die Messreihe für jeden Messpunkt mit der Prüffunktion multipliziert wird, um für jeden Messpunkt ein Prüfprodukt zu erhalten, Aufaddieren der Prüfprodukte unter Berücksichtigung ihres Vorzeichens zu einer Produktsumme und Bewerten in Abhängigkeit der Produktsumme, ob die Messreihe eine niederfrequente Schwingung mit einer Frequenz im Bereich der Prüffrequenz aufweist.

Fig. 6

EP 4 568 047 A2

**Beschreibung**

Die vorliegende Erfindung betrifft ein Verfahren zum Erkennen niederfrequenter Schwingungen, insbesondere subsynchroner Resonanzen, in einem elektrischen Versorgungsnetz. Die vorliegende Erfindung betrifft auch ein Windenergiesystem, nämlich eine Windenergieanlage oder einen Windpark, zum Erkennen niederfrequenter Schwingungen, insbesondere subsynchroner Resonanzen in einem elektrischen Versorgungsnetz.

Viele elektrische Versorgungsnetze weisen zunehmend regenerative Energieerzeuger, insbesondere Windenergieanlagen oder Windparks auf. Ihr steigender Anteil im elektrischen Versorgungsnetz führt dazu, dass es auch zunehmend wichtiger wird, Windenergieanlagen und Windparks zum Stützen des elektrischen Versorgungsnetzes zu verwenden, oder zumindest mit zu berücksichtigen.

Ein Problem, das im elektrischen Versorgungsnetz, das auch vereinfachend als Netz bezeichnet werden kann, auftreten kann, sind Schwingungen, nämlich Schwingungen des Energiesystems, die auch als "Power System Oscillations" (PSO) bezeichnet werden können. Ihre Ursache kann sehr vielfältig sein und ein anschauliches und einfaches Beispiel ist, dass zwei direkt gekoppelte Synchrongeneratoren konventioneller Kraftwerke, die beispielsweise über 100 Kilometer voneinander entfernt einspeisen, gegeneinander schwingen.

Es kommt aber auch in Betracht, dass bereits ein einzelner direkt mit dem elektrischen Versorgungsnetz gekoppelter Synchrongenerator aufgrund einer lokalen Anregung, wie einem Sprung der Leistungsabnahme der angeschlossenen Verbraucher, angeregt wird, mit seiner Eigenfrequenz zu schwingen. Herkömmliche elektrische Versorgungsnetze begegnen solchen Problemen regelmäßig durch entsprechend stabile Regelungen der direkt in das elektrische Versorgungsnetz einspeisenden Synchrongeneratoren. Eine hohe Trägheit dieser Synchrongeneratoren zusammen mit einem physikalisch bedingten und/oder durch den konstruktiven Aufbau des jeweiligen Generators bedingten Dämpfungsverhalten verhindert bei herkömmlichen Netzen regelmäßig ein zu starkes Auftreten solcher Schwingungen.

Regenerative Erzeuger, insbesondere Windenergieanlagen oder Windparks, weisen aber von sich aus solche Eigenschaften nicht auf. Insbesondere weisen sie praktisch keine physikalisch bedingten Eigenschaften auf, die solchen niederfrequenten Schwingungen entgegenwirken können, oder solche niederfrequenten Schwingungen von vornherein vermeiden könnten.

Stattdessen speisen moderne Windenergieanlagen oder Windparks heutzutage mittels Frequenzumrichtern unter Verwendung eines sogenannten Vollumrichterkonzepts in das elektrische Versorgungsnetz ein. Demnach wird die gesamte eingespeiste Leistung durch den, bzw. die Wechselrichter nach genauen Vorgaben in das elektrische Versorgungsnetz eingespeist. Diese Vorgaben betreffen besonders Amplitude, Frequenz und Phase des eingespeisten elektrischen Stroms und diese Vorgabe kann über einen Prozessrechner vorgegeben werden. Dabei ist wenig Raum für physikalisch bedingte Reaktionen oder Anpassungen des eingespeisten Stroms.

Um dennoch auf Phänomene im elektrischen Versorgungsnetz reagieren zu können, insbesondere, um auf niederfrequente Schwingungen, also sogenannte PSO reagieren zu können, müssten solche Schwingungen somit zunächst erfasst werden, idealerweise nach Frequenz, Phasenlage und Amplitude. Darauf basierend könnte dann in den Prozessrechner eine gewünschte Reaktionsmaßnahme berechnet werden, um diese dann mittels des Wechselrichters umzusetzen.

Sofern eine solche niederfrequente Schwingung aber nicht ausreichend genau erfasst wird, können etwaige Gegenmaßnahmen sogar die aktuelle Situation verschlechtern. Dabei kann eine solche Erfassung niederfrequenter Schwingungen schwierig sein, weil diese niederfrequenten Schwingungen zunächst mit vergleichsweise geringer Amplitude der Netzfrequenz, also dem 50 Hz oder 60 Hz Spannungssignal im elektrischen Versorgungsnetz überlagert sind. Besonders bei der Spannungsmessung im elektrischen Versorgungsnetz kommt hinzu, dass mit Störungen und/oder Rauschen zu rechnen ist. Zudem fluktuieren solche niederfrequenten Schwingungen regelmäßig. Besonders treten sie je nach Anregung schwach oder stark oder gar nicht auf.

Trotz dieser Messprobleme ist aber eine möglichst schnelle Erfassung wünschenswert. Das steht wiederum einer längerfristigen Analyse entgegen.

Es kommt das Problem hinzu, dass solche niederfrequenten Schwingungen in einem Frequenzbereich von 0,05 Hz, oder sogar noch niedriger, bis hin zu Frequenzwerten kurz unter der Netzfrequenz liegen können, also bis zur Größenordnung von 50 bis 60 Hz, oder sogar noch etwas höher. Rein physikalisch bedingt benötigt die Erfassung einer sinusförmigen Schwingung eine Messung über die Zeitdauer wenigstens einer Halbperiode dieser Schwingung. Bei einem großen Frequenzspektrum ist zu dessen Erfassung somit eine Messdauer zumindest über eine Halbperiode der Schwingung mit der geringsten zu erwartenden Frequenz erforderlich.

Das Deutsche Patent- und Markenamt hat in der Prioritätsanmeldung zu vorliegender Anmeldung folgenden Stand der Technik recherchiert: DE 37 33 555 A1 und US 4,031,462 A.

Der vorliegenden Erfindung liegt somit die Aufgabe zugrunde, zumindest eins der oben genannten Probleme zu adressieren. Insbesondere soll eine Lösung vorgeschlagen werden, die eine möglichst schnelle Erfassung niederfrequenter Schwingungen ermöglicht, während sie gleichzeitig auch sehr niederfrequente Schwingungen erfassen kann.

Zumindest soll zu bisher bekannten Lösungen eine alternative Lösung vorgeschlagen werden.

Erfindungsgemäß wird ein Verfahren nach Anspruch 1 vorgeschlagen. Dieses Verfahren dient zum Erkennen niederfrequenter Schwingungen in einem elektrischen Versorgungsnetz, insbesondere zum Erkennen subsynchroner Resonanzen in einem elektrischen Versorgungsnetz. Dabei wird von einem elektrischen Versorgungsnetz ausgegangen, das eine Netzspannung mit einer Netznennfrequenz aufweist, wobei die zu erkennenden niederfrequenten Schwingungen vorzugsweise eine geringere Frequenz als die Netznennfrequenz aufweisen. Hier wird also insbesondere als niederfrequente Schwingung bezeichnet und betrachtet, was eine geringere Frequenz als die Netznennfrequenz hat. Vorzugsweise wird von einer Frequenz der niederfrequenten Schwingungen ausgegangen, die kleiner als die halbe Netznennfrequenz ist.

Besonders können die niederfrequenten Schwingungen Werte von 1 Hz und weniger aufweisen. Sie können aber auch bis zum fünffachen Wert der Netznennfrequenz reichen. Als niederfrequente Schwingungen werden hier Schwingungen mit einer Frequenz von maximal dem fünffachen Wert der Netznennfrequenz bezeichnet, vorzugsweise mit einer Frequenz die maximal der Netznennfrequenz entspricht. Besonders weist die niederfrequente Schwingung keine Frequenz auf, die einem Vielfachen der Netznennfrequenz entspricht. Es ist zu beachten, dass die Untersuchung und Berücksichtigung niederfrequenter Schwingungen besonders der Untersuchung oder dem Sicherstellen einer Systemstabilität des elektrischen Versorgungsnetzes dient. Das grenzt sich von einer Beurteilung der Netzqualität bzw. Signalqualität des Spannungssignals im elektrischen Versorgungsnetz ab, bei der es besonders auf Oberschwingungen, insbesondere ganzzahlige Oberschwingungen ankommt.

Das Verfahren schlägt vor, wenigstens eine, mehrere Messpunkte aufweisende Messreihe über einen Messzeitraum aufzunehmen, um darauf basierend eine Frequenzanalyse durchzuführen. Die Messreihe weist also mehrere Messpunkte bzw. Messwerte auf, die nämlich über den Messzeitraum verteilt sind bzw. über den Messzeitraum verteilt aufgenommen wurden.

Als Netzgröße werden insbesondere die Netzspannung, ein in das elektrische Versorgungsnetz eingespeister Einspeisestrom oder eine Netzfrequenz aufgenommen.

Für diese Messreihe wird dann ein Multiplizieren der Messreihe mit einer von der Zeit abhängigen sinusförmigen Prüffunktion für denselben Messzeitraum vorgeschlagen. Eine solche sinusförmige Prüffunktion kann als Funktion auf einen Prozessrechner bereitgestellt werden. Es wird vorgeschlagen, dass die Prüffunktion durch eine Prüffrequenz und einen Prüfwinkel als Phasenwinkel gekennzeichnet ist. Die Amplitude kann auch vorgegeben sein, in der praktischen Umsetzung kommt aber regelmäßig eine Normierung der Amplitude bspw. auf den Wert 1 in Betracht. Der Scheitelwert der sinusförmigen Größe kann demnach bspw. den Wert 1 annehmen, wobei die Skalierung im Prozessrechner bekannt sein kann.

Das Multiplizieren der Messreihe mit der Prüffunktion erfolgt so, dass die Messreihe für jeden Messpunkt mit der Prüffunktion multipliziert wird, um für jeden Messpunkt ein Prüfprodukt zu erhalten. Es wird also ein Messwert zum Messpunkt der Messreihe mit dem entsprechenden Funktionswert der Prüffunktion multipliziert und das wird für jeden Messpunkt wiederholt. Die Prüffunktion wird entsprechend für eine Zeitdauer vorgegeben, die dem Messzeitraum entspricht bzw. die Prüffunktion wird für den Messzeitraum bestimmt. Die Multiplikation erfolgt dann jeweils für jeden Zeitpunkt des Messzeitraums, zu dem ein Messwert vorliegt. Dieser Messwert wird dann mit dem Funktionswert der Prüffunktion desselben Zeitpunktes multipliziert.

Die Prüfprodukte werden nun unter Berücksichtigung ihres Vorzeichens zu einer Produktsumme aufaddiert. Negative Prüfprodukte werden also dem Betrage nach abgezogen. Jedes Prüfprodukt kann nämlich ein negatives Vorzeichen haben, wenn entweder der betreffende Messwert oder der betreffende Funktionswert negativ waren.

In Abhängigkeit der Produktsumme wird dann bewertet, ob die Messreihe eine niederfrequente Schwingung mit einer Frequenz im Bereich der Prüffrequenz und optional mit einem Phasenwinkel im Bereich des Prüfwinkels aufweist.

Hier liegt besonders die folgende Überlegung zu Grunde. Ist die Prüffunktion und die Messreihe nach Frequenz und Phase identisch, wird jedes Prüfprodukt einen positiven Wert aufweisen und entsprechend wird die Produktsumme ebenfalls positiv mit vergleichsweise großer Amplitude sein. Dann gibt die Messreihe eine Funktion wieder, die der Prüffunktion entspricht.

Sind die Messreihe und die Prüffunktion identisch, aber um 90° zueinander Phasenverschoben, so würden die Prüfprodukte eine sinusförmige Funktion (übrigens mit der doppelten Frequenz für die Prüffunktion) ergeben, und zwar ohne Gleichanteil. Die Produktsumme wäre dann, jedenfalls wenn der Untersuchungszeitraum einem ganzzahligen Vielfachen der Periode des untersuchten Signals entspricht, null. Das Phänomen ist dem Elektroingenieur im Übrigen als Blindleistung bekannt, wenn Strom und Spannung um 90° zueinander verschoben sind. Das erstgenannte Beispiel ohne Phasenverschiebung entspräche einem Fall ausschließlich mit Wirkleistung. Es ergäbe sich nämlich ein sinusförmiges Signal doppelter Frequenz, das so stark um die horizontale Achse verschoben ist, dass gerade die kleinsten Werte der Sinusfunktion die horizontale Achse berühren würden. Diese Verschiebung kann auch als Gleichanteil aufgefasst oder bezeichnet werden. Hier wäre also der Gleichanteil sehr hoch, nämlich am höchsten.

Aber auch Abweichungen der Frequenz zwischen Messreihe und Prüffunktion können zu unterschiedlichen Gleichanteilen führen. Die Produktsumme, die somit als Gleichanteil interpretiert werden kann bzw. für den Gleichanteil repräsentativ sein kann, kann somit auch als Maß der Korrelation zwischen der Messreihe und der Prüffunktion stehen. Sind die Messreihe und die Prüffunktion vollständig unkorreliert, wird der Gleichanteil null, jedenfalls theoretisch für einen unendlichen Messzeitraum.

Aber auch in praktischer Ausführung ist die Produktsumme zumindest vergleichsweise klein, wenn die Messreihe und die Prüffunktion unkorreliert sind. Sind die Messreihe und die Prüffunktion gut korreliert und passen auch die Phasenwinkel der Messreihe und der Prüffunktion zueinander, so ergibt sich ein hoher Gleichanteil bzw. eine große Produktsumme. Daraus lässt sich das Vorliegen einer niederfrequenten Schwingung nach Frequenz und Phase ableiten. Die niederfrequente Schwingung hat dann nämlich die Frequenz der Prüffunktion und den Phasenwinkel entsprechend des Prüfwinkels der Prüffunktion.

Bevorzugt wird beim Erkennen einer niederfrequenten Schwingung eine Amplitude der niederfrequenten Schwingung erfasst, insbesondere in Abhängigkeit der Produktsumme. Es wurde besonders erkannt, dass über das Verfahren zum Erkennen einer niederfrequenten Schwingung nach Frequenz und Phase auch die Amplitude bestimmt werden kann.

Vorzugsweise wird das Verfahren so ausgeführt, dass das Multiplizieren der Messreihe mit der Prüffunktion und das Aufaddieren der Prüfprodukte zu einer Produktsumme unter Variation der Prüffrequenz und unter Variation des Prüfwinkels wiederholt wird, um dabei mehrere Produktsummen zu erhalten. Grundsätzlich ist es auch vorteilhaft, nur die Prüffrequenz oder den Prüfwinkel zu variieren, aber solange weder die zu erkennende Frequenz des niederfrequenten Signals, noch dessen Phase bekannt ist, ist es meist vorteilhaft, Prüffrequenz und Prüfwinkel zu variieren. Werden beide Werte variiert, kann das Ergebnis der Produktsummen auch als gekrümmte Ebene dargestellt werden. Dann würde die Produktsumme in Abhängigkeit der Prüffrequenz und des Prüfwinkels dargestellt werden. Es ergäbe sich dann bei der Prüffrequenz und dem Prüfwinkel, bei dem die beste Übereinstimmung zwischen Messreihe und Prüffunktion besteht, ein lokales Maximum.

Somit wird vorgeschlagen, dass das Bewerten, ob die Messreihe eine niederfrequente Schwingung aufweist in Abhängigkeit der so erhaltenen mehreren Produktsummen durchgeführt wird. Es können also alle dabei erhaltenen Produktsummen gegenübergestellt werden und daraus lässt sich das Vorliegen einer niederfrequenten Schwingung erkennen, soweit sie denn eine Frequenz und eine Phase aufweist, die jeweils in der Nähe der Prüffrequenz bzw. des Prüfwinkels liegen.

Insbesondere wird somit bei einer Produktsumme mit maximaler Amplitude in Bezug auf die übrigen Produktsummen eine niederfrequente Schwingung mit der Frequenz und der Phase der zugehörigen Prüffrequenz und des zugehörigen Prüfwinkels angenommen. Für diese Auswertung aller Produktsummen ist es nicht unbedingt erforderlich, eine oben genannte dreidimensionale Darstellung zu wählen. Es kommt auch in Betracht, lediglich nach maximalen Werten der Produktsummen zu suchen, oder im einfachsten Fall nach der maximalen Produktsumme.

Besonders wird somit vorgeschlagen, dass das Multiplizieren der Messreihe mit der Prüffunktion und das Aufaddieren der Prüfprodukte zu einer Produktsumme unter Variation der Prüffrequenz und unter Variation des Prüfwinkels wiederholt wird, sodass zu jedem aus einem Prüffrequenzwert und einem Wert des Prüfwinkels gebildeten Prüfpaar eine Produktsumme aufgenommen wird. Dies erfolgt insbesondere so, dass die aufgenommenen Produktsummen abhängig der Prüffrequenzwerte und abhängig der Prüfwinkel als gekrümmte Fläche im dreidimensionalen Raum darstellbar sind, wobei sie nicht unbedingt dargestellt werden müssen.

Dabei wird besonders zur Bewertung vorgeschlagen, dass bei einer Produktsumme mit maximaler Amplitude in Bezug auf die übrigen Produktsummen eine niederfrequente Schwingung mit der Frequenz und der Phase der zugehörigen Prüffrequenz und des zugehörigen Prüfwinkels angenommen wird. Grundsätzlich kommt natürlich auch in Betracht, zu interpolieren, wenn mehrere benachbarte Produktsummen ein Maximum bilden, also gleich oder fast gleich groß sind.

Dadurch ist insbesondere auch eine Bewertung vollautomatisch programmierbar. Im Grunde braucht nur der zu prüfende Frequenzbereich vorgegeben zu werden. Ggf. kann noch die Schrittweite vorgegeben werden, mit der die Prüffrequenz variiert wird.

Der Prüfwinkel wird bevorzugt von 0° bis 360° durchgeprüft bzw. durchvariiert. Ggf. kommt in Betracht, ihn nur von 0° bis 180° durchzuprüfen und bei der Suche nach der maximalen Produktsumme die dem Betrage nach maximale Produktsumme zu suchen.

Gemäß einer Ausführungsform wird vorgeschlagen, dass zur Annahme einer niederfrequenten Schwingung einer Produktsumme ausschließlich oder zusätzlich geprüft wird, ob die Produktsumme wenigstens eine vorbestimmte Prüfamplitude erreicht. Dem liegt besonders die Annahme zu Grunde, dass alleine schon auf Grund der praktischen Durchführung in jedem Fall eine maximale Produktsumme erwartet werden darf, wenn, wie beschrieben, Prüffrequenzen und Prüfwinkel durchvariiert werden. Daraus wäre dann noch nicht ableitbar, dass tatsächlich eine niederfrequente Schwingung bzw. eine relevante niederfrequente Schwingung vorliegt, denn sehr kleine Maxima können auch durch Messungenauigkeiten oder andere Einflüsse hervorgerufen sein.

Die Prüfung, ob die Produktsumme wenigstens eine vorbestimmte Prüfamplitude erreicht hat, ermöglicht auch, ggf. mehrere niederfrequente Schwingungen zu erkennen, sollten mehrere niederfrequente Schwingungen vorliegen.

Besonders kann, um die anschauliche Erklärung basierend auf der gekrümmten Fläche der Produktsumme zu wählen, durch das Prüfen auf das Erreichen einer vorbestimmten Prüfamplitude auch ein lokales Maximum in dieser gekrümmten Fläche gefunden werden.

Natürlich ist bei mehreren Produktsummen, die hinsichtlich Frequenz und Phasenwinkel benachbart zu einander oder zumindest nahe bei einander liegen, meist nicht von dem Vorliegen mehrerer niederfrequenter Schwingungen auszugehen. Eine solche Häufung großer Produktsummen weist dann auf ein Maximum hin, innerhalb dessen vorzugsweise die maximale Produktsumme als diejenige gewählt wird, deren Prüffrequenz und Prüfwinkel als Frequenz und Phase einer erkannten niederfrequenten Schwingung anzunehmen ist.

Gemäß einer Ausführungsform wird vorgeschlagen, dass in einer ersten Prüfschleife das Multiplizieren der Messreihe mit der Prüffunktion und das Aufaddieren der Prüfprodukte unter Variation der Prüffrequenz wiederholt wird. Die Prüffrequenz wird dabei in einem ersten Frequenzbereich variiert, um eine niederfrequente Schwingung mit einer Schwingfrequenz zu erkennen. Die Schwingfrequenz wird zunächst mit einer ersten Genauigkeit erfasst. In einer zweiten Prüfschleife wird das Multiplizieren der Messreihe mit der Prüffunktion und das Aufaddieren der Prüfprodukte unter Variation der Prüffrequenz wiederholt. Die Prüffrequenz wird dann, bei dieser Wiederholung in der zweiten Prüfschleife, in einem zweiten Frequenzbereich variiert. Dafür wird der zweite Frequenzbereich in Abhängigkeit der in der ersten Prüfschleife erkannten Schwingfrequenz gewählt, um die Schwingfrequenz mit höherer Genauigkeit als in der ersten Schleife zu erfassen.

Hier liegt besonders der Gedanke zu Grunde, dass das Durchprüfen vieler Prüffrequenzen und vieler Prüfwinkel zu einer hohen Anzahl Prüfungen führen kann. Somit wird vorgeschlagen, eine erste Prüfschleife vorzuschalten, die nur die Prüffrequenz variiert, ggf. mit einer ersten Frequenzschrittweite, die größer als eine spätere zweite Frequenzschrittweite ist, mit der in der zweiten Prüfschleife variiert wird. Durch eine solche erste Prüfschleife sollte zumindest in der Nähe einer Frequenz einer niederfrequenten Schwingung eine dem Betrage nach erste Überhöhung auftreten.

Im Bereich dieser ersten Überhöhung kann dann genauer geprüft werden. Dazu wird der zweite Frequenzbereich vorgegeben, der insbesondere kleiner als der erste Frequenzbereich ist, insbesondere dabei in dem ersten Frequenzbereich liegt. In dieser zweiten Prüfschleife kann dann außerdem der Prüfwinkel variiert werden. Damit ist eine hohe Genauigkeit erzielbar, ohne dass diese hohe Genauigkeit in dem gesamten theoretischen Bereich durchgeführt werden muss, der sich durch den ersten Frequenzbereich und einen vollständigen 360°-Bereich für den Prüfwinkel ergibt.

Vorzugsweise wird dabei in der ersten Prüfschleife das Multiplizieren der Messreihe mit der Prüffunktion und das Aufaddieren der Prüfprodukte zusätzlich unter Variation des Prüfwinkels wiederholt. Es werden also Prüffrequenz und Prüfwinkel variiert. Der Prüfwinkel wird dabei in einem ersten Winkelbereich variiert, insbesondere im Bereich von 0° bis 360°, der vorzugsweise aber auch auf 0° bis 180° bzw. einen anderen 180° umfassenden Bereich eingeschränkt sein kann. Das erfolgt, um die niederfrequente Schwingung zusätzlich mit einem Phasenwinkel der Schwingung zu erkennen. Außerdem kann die Produktsumme trotz gut übereinstimmender Frequenz zwischen niederfrequenter Schwingung und Prüffunktion einen dem Betrage nach geringen Wert aufweisen, wenn Phasenwinkel und Prüfwinkel stark voneinander abweichen. Dann könnte eine niederfrequente Schwingung übersehen werden.

Weiterhin wird dazu vorgeschlagen, dass der Prüfwinkel mit einer ersten Winkelschrittweite variiert wird, also bspw. in 5°-Schritten. In der zweiten Prüfschleife wird das Multiplizieren der Messreihe mit der Prüffunktion und das Aufaddieren der Prüfprodukte zusätzlich unter Variation des Prüfwinkels wiederholt, wobei der Prüfwinkel in einem zweiten Winkelbereich variiert wird. Diese Variation erfolgt vorzugsweise mit einer zweiten Winkelschrittweite, die kleiner ist als die erste Winkelschrittweite, bspw. mit einer zweiten Winkelschrittweite von 1°. Besonders wird der zweite Winkelbereich in Abhängigkeit des in der ersten Prüfschleife erkannten Phasenwinkels der Schwingung gewählt, um den Phasenwinkel der Schwingung mit höherer Genauigkeit als in der ersten Schleife zu erfassen.

Es wird somit vorgeschlagen, in der ersten Prüfschleife die Prüffrequenz und den Prüfwinkel zu variieren und dadurch eine erste Groberkennung für wenigstens eine niederfrequente Schwingung durchzuführen, nämlich einen ungefähren Wert der Frequenz der niederfrequenten Schwingung und einen ungefähren Wert des Phasenwinkels der niederfrequenten Schwingung zu bestimmen. In einem Bereich um diese Frequenz und diesen Winkel herum kann dann die Suche verbessert werden, indem dort in einem kleineren Frequenzbereich und auch einem kleineren Winkelbereich die Prüffrequenz und der Prüfwinkel durchgeprüft werden.

Gemäß einer Ausführungsform wird vorgeschlagen, dass in der ersten Prüfschleife die Prüffrequenz in größeren Frequenzschritten variiert wird als in der zweiten Prüfschleife, und außerdem oder alternativ in der ersten Prüfschleife der Prüfwinkel in größeren Winkelschritten variiert wird, als in der zweiten Prüfschleife. Dadurch kann in der ersten Prüfschleife mit vertretbarem Aufwand ein großer Frequenzbereich durchgeprüft werden. Auch kann ein großer Winkelbereich, nämlich insbesondere der vollständige Winkelbereich von 0 bis 360°, zumindest 0 bis 180°, durchgeprüft werden. Damit kann eine erste Lokalisierung einer niederfrequenten Schwingung bei trotzdem vertretbarem Aufwand durchgeführt werden. Eine präzise Suche ist dann in der zweiten Prüfschleife mit höherer Genauigkeit nur noch für einen kleineren Bereich erforderlich, nämlich sowohl einen kleineren Frequenzbereich, als auch einen kleineren Winkelbereich.

Gemäß einer weiteren Ausgestaltung wird vorgeschlagen, dass mehrere Messreihen der Netzgröße aufgenommen werden. Es werden also mehrere Messreihen, insbesondere der Netzspannung, des Einspeisestroms bzw. der Netzfrequenz aufgenommen. Dabei ist jede Messreihe zum Analysieren eines Frequenzbereichs vorgesehen. Dazu wird für jede Messreihe ein Messzeitraum in Abhängigkeit des zu analysierenden Frequenzbereichs ausgewählt. Es werden also unterschiedliche Frequenzbereiche untersucht und dafür jeweils entsprechende Messreihen aufgenommen. Besonders wird dazu vorgeschlagen, den Messzeitraum zum Analysieren eines Frequenzbereichs geringer Frequenz lang zu wählen, nämlich so lang, dass auch die niedrigste Frequenz des Frequenzbereichs noch erfasst werden kann. Entsprechend kann für einen Frequenzbereich höherer Frequenz ein kürzerer Messzeitraum vorgesehen sein. Außerdem wird vorzugsweise vorgeschlagen, dass bei entsprechend langen Messzeiträumen die Messzeitpunkte weiter auseinanderliegen, als bei einem kürzeren Messzeitraum.

Es wird also vorgeschlagen, besonders einen insgesamt zu untersuchenden Frequenzbereich wie bspw. 0,1 Hz oder darunter bis 50 Hz oder sogar 250 Hz eine Aufteilung in wenigstens zwei Messbereiche vorzunehmen, insbesondere in einen niederfrequenten Frequenzbereich und einen höherfrequenten Frequenzbereich. Es wird also in einen ersten und einen zweiten Frequenzbereich unterteilt, ggf. in noch weitere Frequenzbereiche. Für jeden zu analysierenden Frequenzbereich, also, um das Beispiel aufzugreifen, für den niederfrequenten Frequenzbereich und den höherfrequenten Frequenzbereich, wird eine Messreihe aufgenommen. Für das genannte Beispiel werden also zwei Messreihen aufgenommen.

Für jede Messreihe wird dann das Multiplizieren der Messreihe mit der Prüffunktion und das Aufaddieren der Prüfprodukte zu einer Summe unter Variation der Prüffrequenz und außerdem oder alternativ unter Variation des Prüfwinkels wiederholt, um mehrere Produktsummen für jede Messreihe zu erhalten. Weiter wird vorgeschlagen, dass für jede Messreihe jeweils die Produktsummen der betreffenden Messreihe zum Erkennen einer niederfrequenten Schwingung ausgewertet werden.

Dem liegt besonders die Erkenntnis zu Grunde, dass für die Untersuchung eines niederfrequenten Frequenzbereichs einerseits und eines höherfrequenten Frequenzbereichs andererseits unterschiedliche Messzeiten, also Messzeiträume, zu Grunde liegen, die sinnvollerweise betrachtet werden sollten. Andererseits kann ein solcher langer Messzeitraum für eine niederfrequente Schwingung mit vergleichsweise hoher Frequenz zu lang sein, um diese niederfrequente Schwingung rechtzeitig zu erkennen.

Bspw. kann der erste Frequenzbereich, der auch als niederfrequenter Frequenzbereich bezeichnet werden kann, von 0,02 bis 2 Hz reichen. Um eine niederfrequente Schwingung mit 0,02 Hz erfassen zu können, sollte zumindest ein Messzeitraum von dem Kehrwert, also ein Messzeitraum von 50 Sekunden verwendet werden. Der zweite Frequenzbereich, der auch als höherfrequenter Frequenzbereich bezeichnet werden kann, könnte dann bspw. von 2 Hz bis 250 Hz reichen. Hier reicht selbst zum Erfassen der geringsten Frequenz von 2 Hz eine Messzeitdauer von 0,2 Sekunden aus. Dabei kann eine in einem solchen zweiten bzw. höherfrequenten Frequenzbereich liegende Schwingung innerhalb des Prüfzeitraums von 50 Sekunden des ersten Frequenzbereichs sich ggf. signifikant erhöhen, im Extremfall bis hin zu einer Resonanzkatastrophe oder zumindest eine Situation kommen, bei der die Amplitude der niederfrequenten Schwingung so groß geworden ist, dass erste Schäden auftreten können oder erste Abschaltprozesse in Gang gesetzt werden können.

Um diesem Dilemma zu begegnen, wird hier vorgeschlagen, zumindest eine Aufteilung in zwei Frequenzbereiche durchzuführen und insbesondere auch zeitlich voneinander unabhängig die Analysen durchzuführen.

Gemäß einer Ausführungsform wird vorgeschlagen, dass das Multiplizieren der Messreihe mit der Prüffunktion und das Aufaddieren der Prüfprodukte zu einer Produktsumme unter einer bestimmten Variation der Prüffrequenz wiederholt wird. Die Prüffrequenz wird dabei nämlich in wenigstens einem einen oberen und einen unteren Frequenzwert aufweisenden Frequenzbereich mit einer Frequenzschrittweite variiert und dabei wird die Frequenzschrittweite in Abhängigkeit des Frequenzbereichs eingestellt. Das erfolgt insbesondere so, dass die Frequenzschrittweite kleiner als der untere Frequenzwert ist, insbesondere kleiner als 10 % des unteren Frequenzwertes. Außerdem oder alternativ wird vorgeschlagen, dass die Frequenzschrittweite kleiner als ein vorbestimmter Prozentwert ist, insbesondere, dass sie kleiner als 1 %, insbesondere kleiner als 0,2 % des oberen Frequenzwertes eingestellt wird.

Vorzugsweise wird die Prüffrequenz in mehreren Frequenzbereichen variiert und die Frequenzschrittweite unterschiedlicher Frequenzbereiche werden zueinander unterschiedlich eingestellt. Vorzugsweise wird jede Frequenzschrittweite jeweils größer als ein vorbestimmter Prozentteil des jeweiligen unteren Frequenzwertes des betreffenden Frequenzbereichs eingestellt.

Die Prüffrequenz wird also gemäß der jeweiligen Frequenzschrittweite in dem jeweiligen Frequenzbereich variiert. Die Frequenzschrittweite wird dabei in Abhängigkeit des Frequenzbereichs eingestellt und orientiert sich dabei besonders an dem untersten Frequenzwert des jeweiligen Frequenzbereichs. Dafür kann ein prozentualer Wert bezogen auf den unteren Frequenzwert vorgesehen sein. Die Frequenzschrittweite kann sich aber auch an dem oberen Frequenzwert orientieren, wobei sie aber verhältnismäßig viel kleiner in Bezug auf den oberen Frequenzwert des betreffenden Frequenzbereichs gewählt wird. Besonders wird hierdurch erreicht, dass die Variation der Prüffrequenz klar vorgegeben ist und für unterschiedliche Frequenzbereiche auch unterschiedlich gewählt wird. Damit kann der Aufwand des Prüfens, nämlich auf Grund des Aufwandes des Variierens, an den jeweiligen Frequenzbereich angepasst werden. Die Vorgaben ermöglichen auch eine automatisierte Prüfroutine.

Erfindungsgemäß wird auch ein Windenergiesystem vorgeschlagen. Ein solches Windenergiesystem kann eine Windenergieanlage oder ein Windpark mit mehreren Windenergieanlagen sein. Dieses Windenergiesystem speist bestimmungsgemäß in ein elektrisches Versorgungsnetz ein. Es ist vorbereitet zum Erkennen niederfrequenter Schwingungen, insbesondere subsynchroner Resonanzen, in dem elektrischen Versorgungsnetz. Das elektrische Versorgungsnetz weist eine Netzspannung mit einer Netznennfrequenz auf. Das Windsystem umfasst

- ein Aufnahmemittel zum Aufnehmen wenigstens einer, mehrere Messpunkte aufweisenden Messreihe einer Netzgröße, insbesondere der Netzspannung, einem Einspeisestrom oder einer Netzfrequenz, über einen Messzeitraum, zum Durchführen einer Frequenzanalyse,

- eine Multipliziereinheit zum Multiplizieren der Messreihe mit einer von der Zeit abhängigen sinusförmigen Prüffunktion für denselben Messzeitraum, wobei

- die Prüffunktion durch eine Prüffrequenz und einen Prüfwinkel als Phasenwinkel gekennzeichnet ist, und

- die Messreihe für jeden Messpunkt mit der Prüffunktion multipliziert wird, um für jeden Messpunkt ein Prüfprodukt zu erhalten,

- eine Addiereinheit zum Aufaddieren der Prüfprodukte unter Berücksichtigung ihres Vorzeichens zu einer Produktsumme und

- einer Bewertungseinrichtung zum Bewerten in Abhängigkeit der Produktsumme, ob die Messreihe eine niederfrequente Schwingung

- mit einer Frequenz im Bereich der Prüffrequenz und optional

- mit einem Phasenwinkel im Bereich des Prüfwinkels aufweist.

Ein solches Windenergiesystem kann somit in das elektrische Versorgungsnetz einspeisen und übernimmt vorzugsweise auch Stützaufgaben zum Stützen des elektrischen Versorgungsnetzes. Solche Stützaufgaben können besonders dann notwendig werden oder zumindest vorteilhaft sein, wenn dezentrale Erzeuger, wie auch ein solches Windenergiesystem, zu einem signifikanten Anteil in das elektrische Versorgungsnetz bzw. in einen relevanten Abschnitt des elektrischen Versorgungsnetzes einspeisen. Diverse Stützaufgaben können anfallen, wobei eine sein kann, auf eine niederfrequente Schwingung zu reagieren. Vorzugsweise wird eine solche niederfrequente Schwingung aber erst erfasst, möglichst genau nach Frequenz und Phase, ggf. auch nach Amplitude. Dann kann darauf reagiert werden.

Vorzugsweise ist das Windenergiesystem dazu vorbereitet, zumindest ein Verfahren gemäß der vorstehend beschriebenen Ausführungsformen umzusetzen. Insbesondere weist das Windenergiesystem dazu einen Prozessrechner auf, der dazu vorbereitet ist, ein solches Verfahren umzusetzen. Insbesondere ist das Verfahren dazu auf dem Prozessrechner implementiert. Das Implementieren des Verfahrens kann dabei umfassen, dass das Aufnehmen der Messpunkte oder der Messreihe bzw. mehrerer Messreihen dadurch implementiert ist, dass der Prozessrechner entsprechende Werte als Messpunkte bzw. Messwerte empfängt und/oder dass der Prozessrechner das Aufnahmemittel ansteuert, um dadurch die wenigstens eine Messreihe aufzunehmen.

Das Aufnahmemittel kann besonders ein Sensor sein, der bspw. eine Spannung oder einen Strom misst. Die Multipliziereinheit kann ebenfalls in demselben oder einem anderen Prozessrechner implementiert sein. Gleiches gilt für die Addiereinheit, obwohl auch diese Einheiten unterschiedliche Geräteeinheiten ausbilden können. Die Bewertungseinrichtung kann ebenfalls in einem oder demselben Prozessrechner implementiert sein, oder anderweitig als eigenes Element vorgesehen sein.

Nachfolgend wird die Erfindung nun exemplarisch unter Bezugnahme auf die begleitenden Figuren näher erläutert.

Figur 1     zeigt eine Windenergieanlage in einer perspektivischen Darstellung.

Figur 2     zeigt einen Windpark in einer schematischen Darstellung.

Figur 3     zeigt ein Ablaufschema zum Aufnehmen mehrerer Produktsummen bei Variation einer Prüffrequenz und Variation eines Prüfwinkels.

Figur 4     zeigt ein Ablaufdiagramm zum Auswerten mehrerer gemäß dem Ablaufschema der Figur 3 aufgenommener Produktsummen.

Figur 5     zeigt in einem 3-D-Diagramm Produktsummen in Abhängigkeit einer variierten Prüffrequenz und in Abhängigkeit eines variierten Prüfwinkels.

Figur 6     zeigt schematisch eine Struktur eines Windenergiesystems zum Erkennen niederfrequenter Schwingungen.

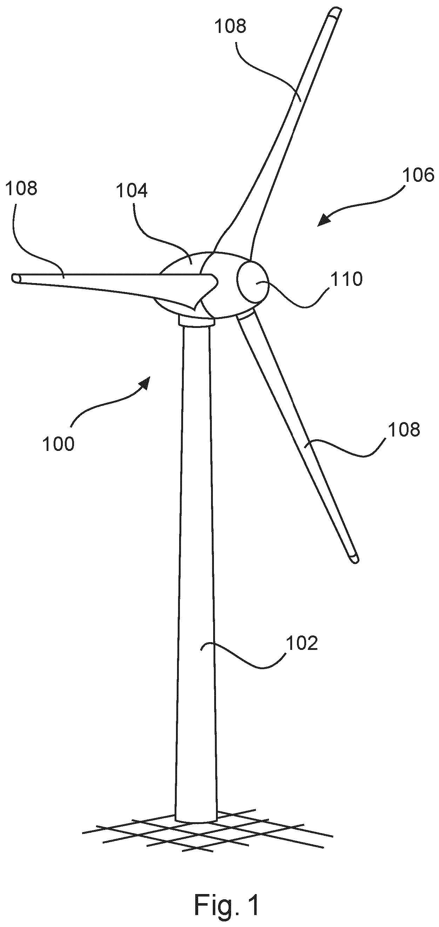

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

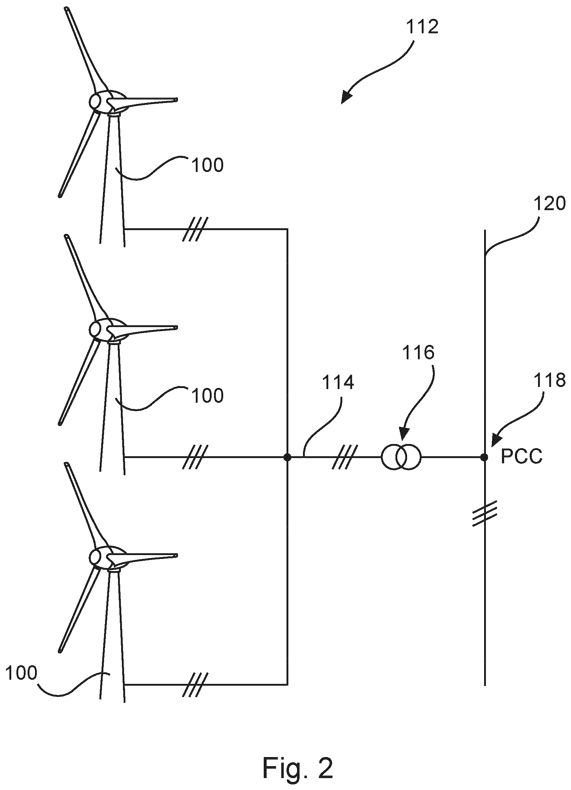

Figur 2 zeigt einen Windpark 112 mit beispielhaft drei Windenergieanlagen 100, die gleich oder verschieden sein können. Die drei Windenergieanlagen 100 stehen somit repräsentativ für im Grunde eine beliebige Anzahl von Windenergieanlagen eines Windparks 112. Die Windenergieanlagen 100 stellen ihre Leistung, nämlich insbesondere den erzeugten Strom über ein elektrisches Parknetz 114 bereit. Dabei werden die jeweils erzeugten Ströme bzw. Leistungen der einzelnen Windenergieanlagen 100 aufaddiert und meist ist ein Transformator 116 vorgesehen, der die Spannung im Park hochtransformiert, um dann an dem Einspeisepunkt 118, der auch allgemein als PCC bezeichnet wird, in das Versorgungsnetz 120 einzuspeisen. Figur 2 ist nur eine vereinfachte Darstellung eines Windparks 112, die beispielsweise keine Steuerung zeigt, obwohl natürlich eine Steuerung vorhanden ist. Auch kann beispielsweise das Parknetz 114 anders gestaltet sein, indem beispielsweise auch ein Transformator am Ausgang jeder Windenergieanlage 100 vorhanden ist, um nur ein anderes Ausführungsbeispiel zu nennen.

Sowohl die Windenergieanlage gemäß Figur 1 als auch der Windpark gemäß Figur 2 können jeweils ein Windenergiesystem bilden.

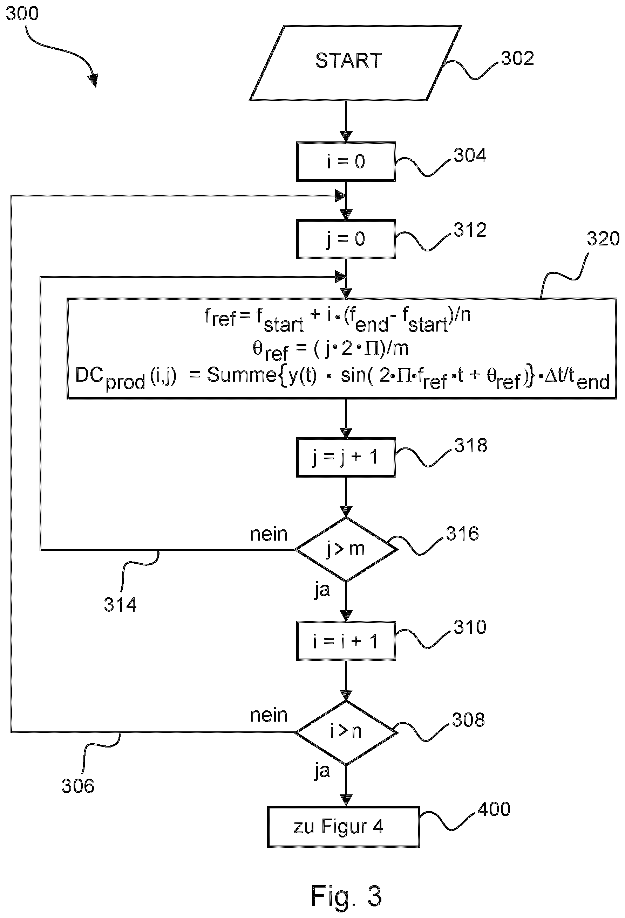

Figur 3 zeigt ein Ablaufdiagramm 300 zum Aufnehmen mehrerer Produktsummen. Im Startblock 302 wird das zu untersuchende Signal aufgenommen und weitere Initialisierungen vorgenommen. Das zu untersuchende Signal kann ein aufgenommenes Zeitsignal sein, das zur Untersuchung in dem Ablaufdiagramm 300 gleichmäßig abgetastet ist mit den Zeitschritten $\Delta t$. Das zu untersuchende Signal kann auch schon in einer solchen abgetasteten Form vorliegen, vorteilhafterweise wird hier aber die Zeitschrittweite gewählt, um damit auch die Anzahl der gesamt zu untersuchenden Werte festzulegen.

Das zu untersuchende Signal y(t) wird somit für einen Messzeitraum aufgenommen bzw. berücksichtigt und der Messzeitraum kann von t = 0 bis t = $t_{end}$ reichen. Die Messdauer und damit Breite des Messzeitraums ist somit durch $t_{end}$ festgelegt. Für die Zeit t gilt somit:

$$t = 0, 1 \cdot \Delta t, 2 \cdot \Delta t, \ldots, t_{end}$$

Ebenfalls kann in dem Startblock 302 der zu untersuchende Frequenzbereich von einer Startfrequenz $f_{start}$ bis zu einer Endfrequenz $f_{end}$ festgelegt werden. Die Schrittweite $\Delta f$ der Frequenzuntersuchung kann abhängig der Startfrequenz $f_{start}$ und der Endfrequenz $f_{end}$ sowie in Abhängigkeit der gewünschten Frequenzschrittanzahl n festgelegt werden, nach der Formel:

$$\Delta f = (f_{end} - f_{start})/n$$

Die Schrittweite der Phasenwinkeluntersuchung $\Delta\varphi$ kann ebenfalls abhängig einer gewünschten Winkelschrittanzahl m festgelegt werden, nach der Formel:

$$\Delta\varphi = (2 \cdot \pi)/m$$

Diese Werte, besonders die Frequenzschrittanzahl n und die Winkelschrittanzahl m und auch der Zeitschritt $\Delta t$ können grundsätzlich beliebig gewählt werden, es wird aber vorgeschlagen, bei der Wahl zwischen Genauigkeit und Rechenaufwand abzuwägen.

In dem ersten Initialisierungsblock 304 wird die Laufvariable i für eine äußere Schleife 306 initialisiert. Die Häufigkeit der Durchläufe dieser äußeren Schleife 306 entspricht der Frequenzschrittanzahl n und das wird entsprechend in dem ersten Wiederholungsabfrageblock 308 geprüft, der sich dem ersten Hochzählblock 310 anschließt.

Innerhalb dieser äußeren Schleife 306 ist der zweite Initialisierungsblock 312, in dem die Laufvariable j für eine innere Schleife 314 initialisiert wird. Sie wird entsprechend der Winkelschrittanzahl m durchlaufen, was in der zweiten Wiederholungsabfrage 316 abgefragt wird, die sich an den zweiten Hochzählblock 318 anschließt.

Schließlich ist ein Berechnungsblock 320 vorgesehen, der entsprechend (n x m)-Mal durchlaufen wird. In jedem Durchlauf wird die Referenzfrequenz $f_{ref}$ berechnet, nämlich die Frequenz, zu der jeweils ein Summenprodukt berechnet wird. Diese Referenzfrequenz $f_{ref}$ berechnet sich nach der Formel:

$$f_{ref} = f_{start} + i \cdot (f_{end} - f_{start})/n$$

Gleichzeitig wird der jeweilige Referenzwinkel $\theta_{ref}$ berechnet, nämlich nach der Formel:

$$\theta_{ref} = (j \cdot 2 \cdot \pi) / m$$

Schließlich wird dann basierend auf diesen berechneten Werten, also für den in dem Durchlauf relevanten Wert für die Referenzfrequenz $f_{ref}$ und den Referenzwinkel $\theta_{ref}$ die Produktsumme berechnet. Die Produktsumme kann auch, wie oben erläutert wurde, als Gleichanteil verstanden werden, so dass die Produktsumme hier als $DC_{prod}$ bezeichnet wird. Sie berechnet sich somit für den jeweiligen Durchlauf i der äußeren Schleife und den jeweiligen Durchlauf j der inneren Schleife nach der Formel:

$$DC_{prod}(i,j) = Summe\{y(t) \cdot \sin(2 \cdot \pi \cdot f_{ref} \cdot t + \theta_{ref})\} \cdot \Delta t/t_{end}$$

Es wird also als Messreihe das zu untersuchende Signal $y(t)$ mit der Sinusfunktion $\sin(2 \cdot \pi \cdot f_{ref} \cdot t + \theta_{ref})$ multipliziert und darüber die Summe gebildet. Es wird also auch hier ein Produkt für jeden Zeitpunkt gebildet und diese Produkte aufsummiert. Das kann bspw. durch eine dritte innerste Schleife durchgeführt werden, um es anschaulich zu erläutern, in der die Zeit t von 0 bis $t_{end}$ hochläuft, nämlich in den Zeitschritten $\Delta t$. Das Ergebnis wird außerdem durch Multiplikation mit dem Zeitschritt $\Delta t$ und Teilung durch die Endzeit $t_{end}$ normiert, nämlich derart, dass die Produktsumme $DC_{prod}$ im Grunde von dem Zeitschritt $\Delta t$ unabhängig ist. Die Produktsumme ist also hinsichtlich ihres absoluten Wertes dem Grunde nach unabhängig von der Anzahl der aufsummierten Produkte.

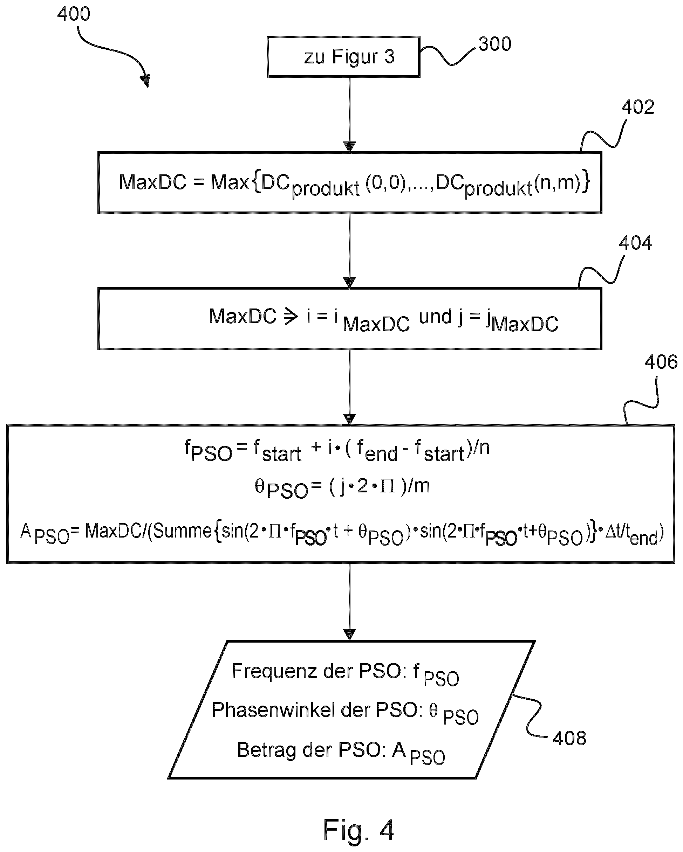

Nachdem die innere Schleife 314 m-mal und die äußere Schleife 306 n-mal durchlaufen wurde, gibt es n x m einzelne Produktsummen $DC_{prod}$ (i, j), die in einem entsprechenden Feld hinterlegt sein können und dann zur weiteren Auswertung untersucht werden können. Dazu wird das Ergebnis des Ablaufdiagramms 300 an das Ablaufdiagramm 400 der Figur 4 übergeben, was in dem Ablaufdiagramm 300 durch den Block 400 angedeutet ist.

Entsprechend zeigt Figur 4 diesen Block 400, nämlich das Ablaufdiagramm 400, und das baut auf auf dem Ablaufdiagramm 300 der Figur 3, was dadurch angedeutet ist, dass der erste Block als Ablaufblock 300 bezeichnet ist.

In dem Max-Block 402 wird von allen Produktsummen, die in dem Berechnungsblock 320 berechnet wurden, die Produktsumme mit dem größten Wert herausgesucht, nämlich unter Berücksichtigung des Vorzeichens. Wenn zur Vereinfachung oder Reduzierung des Aufwandes der Prüfwinkel nicht über 360°, sondern nur über 180° variiert würde - vorzugsweise kommt auch in Betracht, ihn nur über 90° zu variieren -, könnte hier auch der dem Betrage nach größte Wert gesucht werden.

Die Suche erfolgt für alle Produktsummen, die besonders in einem Feld hinterlegt wurden, nämlich je nach Durchlauf der äußeren Schleife 306 und der inneren Schleife 314. Diese wurden nämlich mit der äußeren Laufvariable i und der inneren Laufvariable j durchlaufen und diese beiden Laufvariablen dienen dann hier auch zum Identifizieren der maximalen Produktsumme z.B. in einem Datenfeld. Entsprechend wird im Identifizierungsblock 404 eine Zuordnung dieser beiden Laufvariablen vorgenommen, demnach nämlich die Laufvariablen i und j, zu denen die maximale Produktsumme im Max-Block 402 gefunden wurde, als ausgewählte äußere und ausgewählte innere Laufvariable $i_{MaxDC}$ bzw. $j_{MaxDC}$ identifiziert.

Zu diesen beiden ausgewählten Laufvariablen, nämlich der ausgewählten äußeren und der ausgewählten inneren Laufvariable $i_{MaxDC}$ bzw. $j_{MaxDC}$ gehört der in Block 402 erkannte maximale Wert der Produktsummen und dazu gehört eine Referenzfrequenz und ein Referenzwinkel. Die entsprechende Referenzfrequenz und der entsprechende Referenzwinkel können aus der entsprechenden äußeren bzw. inneren Laufvariable i,j berechnet werden. Für diese Frequenz bzw. diesen Winkel wird davon ausgegangen, dass dies die entsprechende Frequenz einer niederfrequenten Schwingung bzw. der entsprechende Winkel einer niederfrequenten Schwingung ist, sodass diese zugeordnete Referenzfrequenz als Frequenz der niederfrequenten Schwingung $f_{PSO}$ bezeichnet wird und der ausgewählte Winkel als Winkel der niederfrequenten Schwingung $\theta_{PSO}$ bezeichnet wird. Diese beiden Werte lassen sich nach der folgenden Gleichung berechnen:

$$f_{PSO} = f_{start} + i \cdot (f_{end} - f_{start})/n$$

$$\theta_{PSO} = (j \cdot 2 \cdot \pi)/m$$

Und die Frequenz der niederfrequenten Schwingung $f_{PSO}$ und der Winkel der niederfrequenten Schwingung $\theta_{PSO}$ berechnen sich, wenn für die jeweilige äußere bzw. innere Laufvariable i, j die entsprechende ausgewählte Laufvariable $i_{MaxDC}$ bzw. $j_{MaxDC}$ eingesetzt wird. In dieser Formel ist der Winkel der niederfrequenten Schwingung $\theta_{PSO}$ in rad und nicht in Grad angegeben.

In dem Berechnungsblock 406 kann auch eine Amplitude der niederfrequenten Schwingung $A_{PSO}$ berechnet werden, nämlich nach der Gleichung:

$$A_{PSO} = MaxDC/(Summe\{\sin(2 \cdot \pi \cdot f_{PSO} \cdot t + \theta_{PSO}) \cdot sin(2 \cdot \pi \cdot f_{PSO} \cdot t + \theta_{PSO})\} \cdot \Delta t/t_{end})$$

Die Amplitude der niederfrequenten Schwingung ergibt sich also dadurch, dass die erfasste maximale Produktsumme geteilt wird durch eine entsprechende Produktsumme des Referenzsignals multipliziert mit dem Referenzsignal für den gesamten untersuchten Zeitbereich. Es wird also die Produktsumme des Referenzsignals bei Multiplikation mit sich selbst bestimmt, was zu dem maximal möglichen Wert führt, weil eine solche Referenzfunktion zu sich selbst maximal korreliert ist. Es bleibt also ein Faktor zu der weniger korrelierten Produktsumme zwischen untersuchtem Signal und Referenzsignal. Diese Amplitude $A_{PSO}$ ist dabei ebenfalls eine normierte Größe.

Die Ergebnisse können somit in dem Ausgabeblock 408 ausgegeben und weiterverwendet werden.

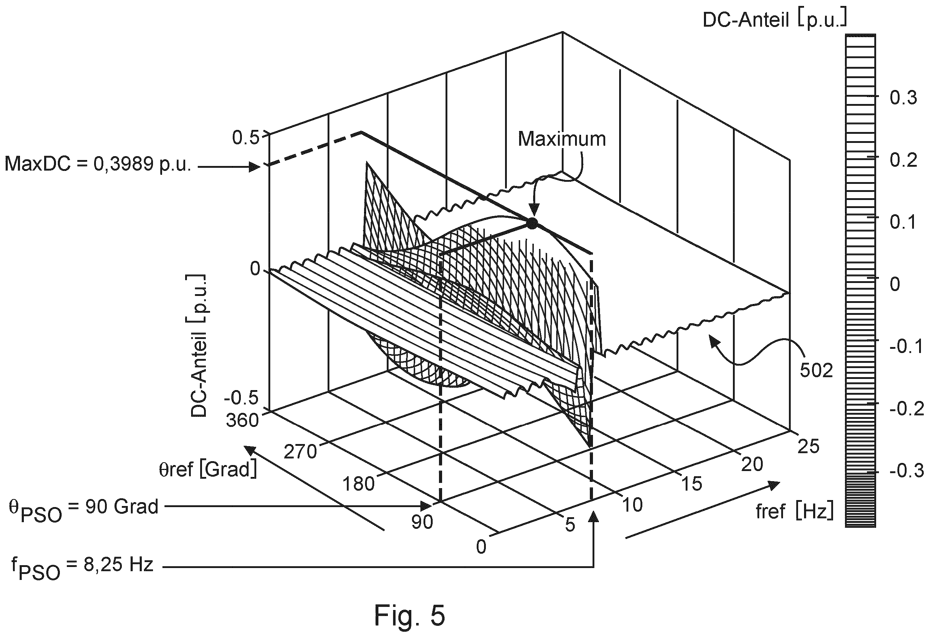

Figur 5 veranschaulicht in einer dreidimensionalen Darstellung 500 die Gesamtheit aller Produktsummen, die in dem Berechnungsblock 320 berechnet wurden, als gekrümmte Ebene 502 in Abhängigkeit der variierten Referenzfrequenz $f_{ref}$ und des variierten Referenzwinkels $\theta_{ref}$. Die Referenzfrequenz $f_{ref}$ kann auch synonym als Prüffrequenz bezeichnet werden und der Referenzwinkel $\theta_{ref}$ kann auch synonym als Prüfwinkel bezeichnet werden.

Beispielhaft ist ein zu untersuchendes Signal gewählt worden, das eine niederfrequente Schwingung mit einer Schwingfrequenz von 8,25 Hz ($f_{PSO}$ = 8,25 Hz) unter einem Phasenwinkel von 90° ($\theta_{PSO}$ = 90°) aufweist. Dazu wurde ein Referenzwinkel bzw. Prüfwinkel von 0° bis 360° durchvariiert und eine Referenzfrequenz bzw. Prüffrequenz von 0 bis 25 Hz durchvariiert. Es ist zu erkennen, dass für von dieser Schwingfrequenz von 8,25 Hz stark abweichende Frequenzen die in der gekrümmten Ebene 502 eingezeichneten Produktsummen im Wesentlichen den Wert 0 aufweisen. In der Nähe der Schwingfrequenz von 8,25 Hz, nimmt die Amplitude oszillierend zur Schwingfrequenz hin zu. Es ist aber auch zu erkennen, dass der Referenzwinkel bzw. der Prüfwinkel ebenfalls eine große Rolle spielt. Bei der Schwingfrequenz und dem Phasenwinkel der niederfrequenten Schwingung ist dann auch die absolute Amplitude der Produktsumme maximal und entsprechend kann aus dem Diagramm bzw. aus dem Wertefeld der Produktsummen die Frequenz der niederfrequenten Schwingung $f_{PSO}$ und der Phasenwinkel der niederfrequenten Schwingung $\theta_{PSO}$ abgelesen werden.

Das Ablaufdiagramm der Figur 3 und indirekt auch der Figur 4 und auch das Diagramm der Figur 5 betreffen den Fall, dass die Prüffrequenz bzw. Referenzfrequenz und auch der Prüfwinkel bzw. der Referenzwinkel nur jeweils einmal variiert wurden, zwar jeweils mit vielen Werten, aber ohne besonders den Gesamtablauf der äußeren und inneren Schleife gemäß dem Ablaufdiagramm 300 mit neuen Werten zu wiederholen. Diese Darstellung besonders der Figur 3 dient insoweit der Veranschaulichung und vorzugsweise wird besonders der gesamte Ablauf gemäß den beiden Ablaufdiagrammen 300 und 400 mit fokussierten Werten für den Bereich der zu untersuchenden Frequenz, also für den zu untersuchenden Frequenzbereich und auch für neue Werte für den zu untersuchenden Winkelbereich wiederholt. Dafür werden in dem Startblock 302 entsprechend neue Werte in der Nähe des grob identifizierten Maximums bestimmt, insbesondere basierend auf den im ersten Durchlauf in dem Ausgabeblock 408 bereitgestellten Werten für die Frequenz der niederfrequenten Schwingung $f_{PSO}$ und den Phasenwinkel der niederfrequenten Schwingung $\theta_{PSO}$.

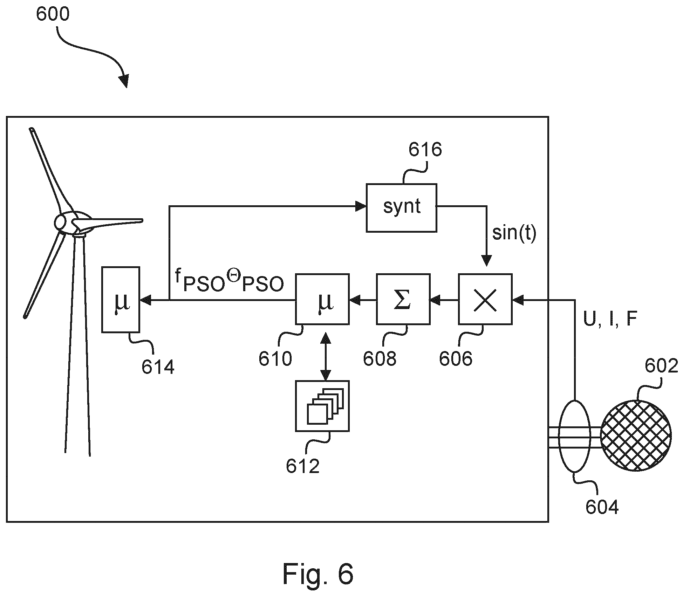

Figur 6 zeigt ein Windenergiesystem 600, das symbolisch durch eine einzelne Windenergieanlage veranschaulicht ist, aber auch mehrere Windenergieanlagen aufweisen kann. Dieses ist vorbereitet zum Erkennen subsynchroner Resonanzen in einem elektrischen Versorgungsnetz 602, in das dieses Windenergiesystem 600 einspeist.

Es ist ein Aufnahmemittel 604 zum Aufnehmen wenigstens einer Messreihe einer Netzgröße vorgesehen, das eine Netzspannung, einen eingespeisten Strom oder eine Netzfrequenz erfassen kann. Die so erfasste Messreihe wird auf eine Multipliziereinheit 606 gegeben, die eine Multiplikation mit einer Prüffunktion sin(t) durchführen kann. Diese Prüffunktion sin(t) ist hier insoweit nur symbolisch genannt und ist, wie auch vorstehend beschrieben wurde, komplexer als eine solche Sinusfunktion, kann zumindest hinsichtlich einiger Eingangsgrößen variiert werden.

Das Ergebnis dieser Multipliziereinheit 606 wird auf eine Addiereinheit 608 gegeben, in der die Prüfprodukte, die in der Multipliziereinheit 606 erzeugt wurden, zu einer Produktsumme aufaddiert wurden. Somit ist eine Produktsumme das Ergebnis der Addiereinheit 608 und das wird auf eine Bewertungseinrichtung 610 gegeben. Die Bewertungseinrichtung sucht dabei nach einem Maximum aller Produktsummen, die sie von der Multipliziereinheit 606 erhalten hat. Dazu kann eine Speichereinrichtung 612 zum Aufnehmen eines Datenfeldes vorgesehen sein, das hier als Teil der Bewertungseinrichtung 610 gezeigt ist. Das Ergebnis der Bewertungseinrichtung ist schließlich, falls eine niederfrequente Schwingung gefunden wurde, ihre Schwingfrequenz $f_{PSO}$ und ihr Phasenwinkel $\theta_{PSO}$. Diese Werte können dann von einem weiteren Prozessrechner 614 weiterverarbeitet werden, um bspw. eine Einspeisung des Windenergiesystems 600 in das elektrische Versorgungsnetz 602 so anzupassen, dass einer solchen erkannten Schwingung entgegengewirkt wird. Außerdem können diese beiden Werte, also die Frequenz und der Phasenwinkel der niederfrequenten Schwingung zurückgeführt werden zu einem Syntheseblock 616, der die bereits beschriebene Prüffunktion, die symbolisch als sin(t) dargestellt ist, erzeugt bzw. in einer weiteren Schleife anpasst. Besonders ihre Eingangswerte werden dabei angepasst.

Somit wurde besonders berücksichtigt, dass die Erkennung niederfrequenter Schwingungen (PSO/ Power System Oscillations) und deren Parameter eine Herausforderung sein kann. Das liegt besonders daran, dass niederfrequente Schwingungen in der Regel sehr niederfrequente Anteile aufweisen. Problematisch ist nicht nur, überhaupt zu erkennen, dass eine Schwingung existiert, sondern dann auch diese zu identifizieren, nämlich besonders zu identifizieren, welche Frequenz vorliegt, welcher Phasenwinkel und welcher Betrag der Schwingung.

Grundsätzlich könnte ein bekanntes DFT-Verfahren angewendet werden. Jedoch wurde erkannt, dass ein solches DFT-Verfahren abhängig der Abtastrate des Signals, Informationen über einen breiten Frequenzbereich liefert, was nicht unbedingt hilfreich ist. Darüber hinaus benötigt ein DFT-Verfahren für feinere Auflösung im Frequenzbereich ein entsprechend langes Zeitfenster im Zeitbereich. Dabei wurde erkannt, dass sich die zu erwartenden Frequenzen im Rahmen niederfrequenter Schwingungen in einem begrenzten Frequenzbereich befinden und dass dies ausgenutzt werden kann, um andere effektive Ansätze, die sich auf einen solchen begrenzten Frequenzbereich konzentrieren, hilfreich sein können. Vorteilhaft ist auch, wenn entsprechende Ansätze ein kürzeres Zeitfenster benötigen.

Der Erfindung liegt auch die Erkenntnis zugrunde, dass Energiesysteme schwingungsfähige Systeme sind, die natürliche Moden unterhalb und oberhalb der Systemfrequenz (50, 60Hz) besitzen. Bei Anregung können solche Schwingungen die Systemstabilität beeinträchtigen, wenn sie nicht ausreichend gedämpft sind. Hier wird nun ein neuer Ansatz zur Detektion von sogenannten Power-System-Oscillations (PSO) vorgeschlagen. Es soll eine mögliche genaue Identifikation der Frequenz, des Phasenwinkels und des Betrages von Power-System-Oscillations (PSO) aus einem Signal erreicht werden.

Die Beobachtung von Power-System-Oscillations (PSO) kann nicht nur als ein Warnungssystem für den Betrieb von Windparks hilfreich sein, sondern diese Information kann auch als Basis zur geeigneten Generierung von Dämpfungssignalen durch Windenergieanlagen bzw. Windparks zur Bedämpfung der Power-System-Oscillations benutzt werden.

Es wurde besonders auch erkannt, dass die Beobachtung von Power-System-Oscillations (PSO), also besonders niederfrequenter Schwingungen, eine wichtige Komponente eines Warnungssystems auch für den Betrieb von Windparks sein kann. Außerdem basieren die meisten Ansätze zur Bedämpfung von PSO auf einer genauen Identifikation einer Schwingung aus einer Messung.

Das vorgeschlagene Verfahren ermöglicht besonders die Identifikation von PSO (oder andere Arten von Schwingungen) und ihrer wichtigsten Merkmale (Frequenz, Phasenwinkel und Betrag).

Das vorgeschlagene, vorliegende Verfahren zielt besonders auf eine mögliche genaue Identifikation der Frequenz, des Phasenwinkels und des Betrages einer Schwingung in einem gemessenen Signal anhand eines möglichst kurzen Messfensters ab. Dabei werden häufige Einschränkungen realer Systeme wie Rechenkapazität, Speicherplatz für die Messdaten, Annahmen bezüglich eines konstanten Arbeitspunktes berücksichtigt.

Der vorgeschlagene Ansatz basiert auf dem Prinzip, dass der Gleichanteil (DC-Anteil) des Produkts des zu untersuchenden Signals mit einem sinusförmigen Referenzsignal, das die Frequenz $f_{ref}$ aufweist, nur mit dem Anteil des Signals in der Frequenz $f_{ref}$ zusammenhängt. Alle anderen Signalteile, die also nicht diese Frequenz des Referenzsignals aufweisen, mitteln sich quasi heraus, um es veranschaulichend auszudrücken.

Die zugrundeliegende Idee lässt sich folgendermaßen zusammenfassen. Das zu untersuchende Signal wird mit einem sinusförmigen Referenzsignal multipliziert. Dabei wird der Phasenwinkel des Referenzsignals durch m Iterationen in einer Schleife im kompletten Bereich (0 bis zu $2\pi$ bzw. 0° bis zu 360°) geändert. Des Weiteren wird die Frequenz des Referenzsignals in einer weiteren Schleife durch n Iterationen im zu untersuchenden Frequenzbereich ($f_{start}$ bis zu $f_{end}$) geändert. Somit ergeben sich m x n Produkte. Die Frequenz und der Phasenwinkel, bei denen der DC-Anteil des Produkts am höchsten ist, können als die Frequenz und der Phasenwinkel der niederfrequenten Schwingung angenommen werden. Durch die Kenntnis der Frequenz und des Phasenwinkels lässt sich auch der Betrag der niederfrequenten Schwingung ermitteln. Dieser Ablauf ist im Wesentlichen in den Figuren 3 und 4 veranschaulicht.

Die Genauigkeit des Ansatzes für einen bestimmten Frequenzbereich ($f_{start}$ bis $f_{end}$) kann durch die Erhöhung der Parameter m und n verbessert werden, wenn also die beiden Schleifen 306 und 314 gemäß Figur 3 häufiger und mit kleineren Schritten durchlaufen werden. Eine Möglichkeit zur Optimierung des Rechenaufwandes ist, den vorgeschlagenen Ansatz gemäß Figuren 3 und 4 in zwei Stufen umzusetzen:

1. Die erste Stufe besitzt eine grobe Auflösung (($f_{end}$ - $f_{start}$) / n) und liefert als Resultat eine grobe Abschätzung der Frequenz von PSO (nachfolgend $f_{PSO1}$). Hierzu werden folgende Werte für die Untersuchungsparameter empfohlen:

$$f_{start1} = f_{start}$$

$$f_{end1} = f_{end}$$

$n_1$ = die nächste ganzzahlige Zahl nach $(f_{end} - f_{start}) \cdot t_{end} \cdot 2$
$m_1 = 36$

2. Im Anschluss untersucht die zweite Stufe einen kleineren Frequenzbereich um das Resultat der ersten Stufe mit einer feineren Auflösung. Hierzu werden folgende Werte für die Untersuchungsparameter empfohlen:

$$f_{start2} = f_{PSO1} - 1/( t_{end} \cdot 2)$$

$$f_{end2} = f_{PSO1} + 1/( t_{end} \cdot 2)$$

$n_2$: Möglichst hoch ($\geq 2$)
$m_2$: Möglichst hoch ($\geq 36$)

$n_1$ und $n_2$ bezeichnen die erste bzw. zweite Wiederholungsanzahl der Schleife zur Frequenzvariation.
$m_1$ und $m_2$ bezeichnen die erste bzw. zweite Wiederholungsanzahl der Schleife zur Phasenwinkelvariation.
Vorteile gegenüber FFT und DFT (Standardverfahren):
Bei der FFT und DFT ist es möglich, nur die Schwingungen mit bestimmten Frequenzen zu identifizieren, nämlich: Schwingungen, deren Frequenzen einem ganzzahligen Mehrfachen von 1/T (T: Länge der Untersuchungszeitfenster) entspricht. Da die Frequenz von PSO eine unbekannte Größe ist, ist es sehr unwahrscheinlich, dass zufällig die Frequenz von PSO einem ganzzahligen Mehrfachen von 1/T entspricht. Daher ist bei der Anwendung von FFT bzw. DFT immer mit einem gewissen Fehler bei der Ermittlung der Frequenz zu rechnen. Der Fehler in Frequenz-Bestimmung beeinträchtigt die Ermittlung von Phasenwinkel und Betrag. Im Gegensatz zur FFT und DFT kann beim vorgeschlagenen Ansatz der Frequenzbereich beliebig fein untersucht werden. Hierbei soll lediglich ein Kompromiss zwischen der Genauigkeit und dem Rechenaufwand getroffen werden. Die FFT liefert als Ergebnis Informationen über bestimme Spektrallinien. Die Anzahl der Spektrallinien hängt mit der Anzahl der Messpunkte des zu untersuchenden Signals zusammen. Bei der FFT ist es nicht möglich, einen Teil dieser Spektrallinien zu untersuchen. Mit anderen Worten gibt es keine Möglichkeit, die FFT-Berechnung für einen begrenzten Frequenzbereich durchzuführen. Demgegenüber kann der Untersuchungsbereich für die Frequenz beim vorgeschlagenen Ansatz beliebig gewählt werden. Des Weiteren wird es möglich, den Rechenaufwand durch die Auswahl der Untersuchungsauflösung passend zu der zur Verfügung stehenden Rechenkapazität zu wählen.

## Patentansprüche

1. Verfahren zum Erkennen niederfrequenter Schwingungen, insbesondere subsynchroner Resonanzen, in einem elektrischen Versorgungsnetz, wobei das elektrische Versorgungsnetz eine Netzspannung mit einer Netznennfrequenz aufweist, umfassend die Schritte

   - Aufnehmen wenigstens einer, mehrere Messpunkte aufweisenden Messreihe einer Netzgröße, insbesondere der Netzspannung, einem Einspeisestrom oder einer Netzfrequenz, über einen Messzeitraum, zum Durchführen einer Frequenzanalyse,
   - Multiplizieren der Messreihe mit einer von der Zeit abhängigen sinusförmigen Prüffunktion für denselben Messzeitraum, wobei
   - die Prüffunktion durch eine Prüffrequenz und einen Prüfwinkel als Phasenwinkel gekennzeichnet ist, und
   - die Messreihe für jeden Messpunkt mit der Prüffunktion multipliziert wird, um für jeden Messpunkt ein Prüfprodukt zu erhalten,
   - Aufaddieren der Prüfprodukte unter Berücksichtigung ihres Vorzeichens zu einer Produktsumme und
   - Bewerten in Abhängigkeit der Produktsumme, ob die Messreihe eine niederfrequente Schwingung
   - mit einer Frequenz im Bereich der Prüffrequenz aufweist.

2. Verfahren nach Anspruch 1,
   **dadurch gekennzeichnet, dass**

   - das Bewerten in Abhängigkeit der Produktsumme auch umfasst, ob die Messreihe eine niederfrequente Schwingung mit einem Phasenwinkel im Bereich des Prüfwinkels aufweist, und/oder dass
   - das Multiplizieren der Messreihe mit der Prüffunktion und das Aufaddieren der Prüfprodukte zu einer Produktsumme unter Variation der Prüffrequenz und/oder unter Variation des Prüfwinkels wiederholt wird, um mehrere Produktsummen zu erhalten, und

- das Bewerten, ob die Messreihe eine niederfrequente Schwingung aufweist in Abhängigkeit der so erhaltenen mehreren Produktsummen durchgeführt wird, insbesondere so, dass
- bei einer Produktsumme mit maximaler Amplitude in Bezug auf die übrigen Produktsummen eine niederfrequente Schwingung mit der Frequenz und der Phase der zugehörigen Prüffrequenz und des zugehörigen Prüfwinkels angenommen wird, und/oder dass
- beim Erkennen einer niederfrequenten Schwingung eine Amplitude der niederfrequenten Schwingung erfasst wird, insbesondere in Abhängigkeit der Produktsumme.

3. Verfahren nach Anspruch 1 oder 2,
   **dadurch gekennzeichnet, dass**

   - das Multiplizieren der Messreihe mit der Prüffunktion und das Aufaddieren der Prüfprodukte zu einer Produktsumme unter Variation der Prüffrequenz und unter Variation des Prüfwinkels wiederholt wird, sodass
   - zu jedem aus einem Prüffrequenzwert und einem Wert des Prüfwinkels gebildeten Prüfpaar eine Produktsumme aufgenommen wird, wobei insbesondere
   - die aufgenommenen Produktsummen abhängig der Prüffrequenzwerte und abhängig der Prüfwinkel als gekrümmte Fläche im dreidimensionalen Raum darstellbar sind, und wobei
   - ein Prüffrequenzwert und ein Prüfwinkel eines Prüfpaares, zu dem die Produktsumme in Bezug auf die übrigen aufgenommenen Produktsummen ein Maximum bildet, als Frequenz und Phasenwinkel einer niederfrequenten Schwingung angenommen wird.

4. Verfahren nach einem der vorstehenden Ansprüche,
   **dadurch gekennzeichnet, dass**
   zur Annahme einer niederfrequenten Schwingung einer Produktsumme ausschließlich oder zusätzlich geprüft wird, ob die Produktsumme wenigstens eine vorbestimmte Prüfamplitude erreicht.

5. Verfahren nach einem der vorstehenden Ansprüche,
   **dadurch gekennzeichnet, dass**

   - in einer ersten Prüfschleife das Multiplizieren der Messreihe mit der Prüffunktion und das Aufaddieren der Prüfprodukte unter Variation der Prüffrequenz wiederholt wird, wobei
   - die Prüffrequenz in einem ersten Frequenzbereich variiert wird, um eine niederfrequente Schwingung mit einer Schwingfrequenz zu erkennen, wobei
   - die Schwingfrequenz mit einer ersten Genauigkeit erfasst wird, und
   - in einer zweiten Prüfschleife das Multiplizieren der Messreihe mit der Prüffunktion und das Aufaddieren der Prüfprodukte unter Variation der Prüffrequenz wiederholt wird, wobei
   - die Prüffrequenz in einem zweiten Frequenzbereich variiert wird, und
   - der zweite Frequenzbereich in Abhängigkeit der in der ersten Prüfschleife erkannten Schwingfrequenz gewählt wird, um die Schwingfrequenz mit höherer Genauigkeit als in der ersten Schleife zu erfassen.

6. Verfahren nach Anspruch 5,
   **dadurch gekennzeichnet, dass**

   - in der ersten Prüfschleife das Multiplizieren der Messreihe mit der Prüffunktion und das Aufaddieren der Prüfprodukte zusätzlich unter Variation des Prüfwinkels wiederholt wird, wobei
   - der Prüfwinkel in einem ersten Winkelbereich variiert wird, insbesondere im Bereich von 0 bis 360°, wobei
   - der Prüfwinkel mit einer ersten Winkelschrittweite variiert wird, und
   - in der zweiten Prüfschleife das Multiplizieren der Messreihe mit der Prüffunktion und das Aufaddieren der Prüfprodukte zusätzlich unter Variation des Prüfwinkels wiederholt wird, wobei
   - der Prüfwinkel in einem zweiten Winkelbereich variiert wird, insbesondere mit einer zweiten Winkelschrittweite, die kleiner als die erste Winkelschrittweite ist, und
   - der zweite Winkelbereich in Abhängigkeit des in der ersten Prüfschleife erkannten Phasenwinkels der Schwingung gewählt wird, um den Phasenwinkel der Schwingung mit höherer Genauigkeit als in der ersten Schleife zu erfassen.

7. Verfahren nach Anspruch 5 oder 6,
   **dadurch gekennzeichnet, dass**

- in der ersten Prüfschleife die Prüffrequenz in größeren Frequenzschritten variiert wird als in der zweiten Prüfschleife, und/oder
- in der ersten Prüfschleife der Prüfwinkel in größeren Winkelschritten variiert wird als in der zweiten Prüfschleife.

8. Verfahren nach einem der vorstehenden Ansprüche,
**dadurch gekennzeichnet, dass**

- mehrere Messreihen der Netzgröße, insbesondere der Netzspannung, des Einspeisestroms bzw. der Netzfrequenz aufgenommen werden, wobei
- jede Messreihe zum Analysieren eines Frequenzbereiches vorgesehen ist,
- für jede Messreihe ein Messzeitraum in Abhängigkeit des zu analysierenden Frequenzbereichs ausgewählt wird, und
- für jede Messreihe das Multiplizieren der Messreihe mit der Prüffunktion und das Aufaddieren der Prüfprodukte zu einer Prüfsumme unter Variation der Prüffrequenz und/oder unter Variation des Prüfwinkels wiederholt wird, um mehrere Produktsummen für jede Messreihe zu erhalten, und
- für jede Messreihe jeweils die Produktsummen der betreffenden Messreihe zum Erkennen einer niederfrequenten Schwingung ausgewertet werden.

9. Verfahren nach einem der vorstehenden Ansprüche,
**dadurch gekennzeichnet, dass**

- das Multiplizieren der Messreihe mit der Prüffunktion und das Aufaddieren der Prüfprodukte zu einer Produktsumme unter Variation der Prüffrequenz wiederholt wird, wobei
- die Prüffrequenz in wenigstens einem einen oberen und einen unteren Frequenzwert aufweisenden Frequenzbereich mit einer Frequenzschrittweite variiert wird, und
- die Frequenzschrittweite in Abhängigkeit des Frequenzbereichs eingestellt wird, insbesondere so, dass
- die Frequenzschrittweite kleiner als der untere Frequenzwert ist, insbesondere kleiner als 10% des unteren Frequenzwertes, und/oder dass
- die Frequenzschrittweite kleiner als ein vorbestimmter Prozentwert, vorzugsweise kleiner als 1%, insbesondere kleiner als 0,2% des oberen Frequenzwertes eingestellt wird,
- wobei vorzugsweise die Prüffrequenz in mehreren Frequenzbereichen variiert wird und die Frequenzschrittweiten unterschiedlicher Frequenzbereiche zu einander unterschiedlich eingestellt werden, wobei vorzugsweise jede Frequenzschrittweite jeweils größer als ein vorbestimmter Prozentteil des jeweiligen unteren Frequenzwertes des betreffenden Frequenzbereichs eingestellt wird.

10. Windenergiesystem, nämlich Windenergieanlage oder Windpark, zum Erkennen niederfrequenter Schwingungen, insbesondere subsynchroner Resonanzen, in einem elektrischen Versorgungsnetz, wobei das elektrische Versorgungsnetz eine Netzspannung mit einer Netznennfrequenz aufweist, und das Windsystem umfasst

- ein Aufnahmemittel zum Aufnehmen wenigstens einer, mehrere Messpunkte aufweisenden Messreihe einer Netzgröße, insbesondere der Netzspannung, einem Einspeisestrom oder einer Netzfrequenz, über einen Messzeitraum, zum Durchführen einer Frequenzanalyse,
- eine Multipliziereinheit zum Multiplizieren der Messreihe mit einer von der Zeit abhängigen sinusförmigen Prüffunktion für denselben Messzeitraum, wobei

- die Prüffunktion durch eine Prüffrequenz und einen Prüfwinkel als Phasenwinkel gekennzeichnet ist, und
- die Messreihe für jeden Messpunkt mit der Prüffunktion multipliziert wird, um für jeden Messpunkt ein Prüfprodukt zu erhalten,

- eine Addiereinheit zum Aufaddieren der Prüfprodukte unter Berücksichtigung ihres Vorzeichens zu einer Produktsumme und
- einer Bewertungseinrichtung zum Bewerten in Abhängigkeit der Produktsumme, ob die Messreihe eine niederfrequente Schwingung
- mit einer Frequenz im Bereich der Prüffrequenz aufweist.

11. Windenergiesystem, nach Anspruch 10, **dadurch gekennzeichnet, dass** es dazu vorbereitet ist, ein Verfahren nach einem der Ansprüche 1 bis 9 umzusetzen, wobei das Windenergiesystem dazu vorzugsweise einen Prozessrechner aufweist, auf dem das Verfahren, zumindest ein Teil davon, implementiert ist, und/oder

die Bewertungseinrichtung zum Bewerten in Abhängigkeit der Produktsumme auch umfasst, ob die Messreihe eine niederfrequente Schwingung mit einem Phasenwinkel im Bereich des Prüfwinkels aufweist.

Fig. 1

Fig. 2

300

START 302

i = 0 304

j = 0 312

320

$$f_{ref} = f_{start} + i \cdot (f_{end} - f_{start})/n$$
$$\theta_{ref} = (j \cdot 2 \cdot \Pi)/m$$
$$DC_{prod}(i,j) = Summe\{y(t) \cdot \sin(2 \cdot \Pi \cdot f_{ref} \cdot t + \theta_{ref})\} \cdot \Delta t/t_{end}$$

j = j + 1 318

nein

j > m 316

314

ja

i = i + 1 310

nein

i > n 308

306

ja

zu Figur 4 400

Fig. 3

400

zu Figur 3 — 300

402

$$MaxDC = Max\{DC_{produkt}(0,0),...,DC_{produkt}(n,m)\}$$

404

$$MaxDC \Rightarrow i = i_{MaxDC} \text{ und } j = j_{MaxDC}$$

406

$$f_{PSO} = f_{start} + i \cdot (f_{end} - f_{start})/n$$

$$\theta_{PSO} = (j \cdot 2 \cdot \Pi)/m$$

$$A_{PSO} = MaxDC/(Summe\{sin(2 \cdot \Pi \cdot f_{PSO} \cdot t + \theta_{PSO}) \cdot sin(2 \cdot \Pi \cdot f_{PSO} \cdot t + \theta_{PSO})\} \cdot \Delta t/t_{end})$$

Frequenz der PSO: $f_{PSO}$

Phasenwinkel der PSO: $\theta_{PSO}$

Betrag der PSO: $A_{PSO}$

408

Fig. 4

DC-Anteil [p.u.]

MaxDC = 0,3989 p.u. →

Maximum

$\theta_{PSO}$ = 90 Grad

$f_{PSO}$ = 8,25 Hz

502

$\theta$ref [Grad]

fref [Hz]

DC-Anteil [p.u.]

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3733555 A1
- US 4031462 A